# EUROPEAN PATENT APPLICATION

(11) **EP 1 619 724 A1**
(43) Date of publication of application: **25.01.2006**
(21) Application number: 04726292.8
(22) Date of filing: 07.04.2004
(51) Int. Cl.: H01L 29/74

(54) **GATE TURN-OFF THYRISTOR**

(30) Priority: 09.04.2003 JP 2003105650
(71) Applicant: THE KANSAI ELECTRIC POWER CO., INC., Osaka-shi, Osaka 530-8270 (JP)
(72) Inventor: ASANO, Katsunori, The Kansai Elec. Power Co., Inc., Osaka-shi, Osaka 5308270 (JP); SUGAWARA, Yoshitaka, The Kansai El. Power Co. Inc., Osaka-shi, Osaka 530 8270 (JP)
(74) Representative: Suckling, Andrew Michael
(86) International application number: PCT/JP2004/005046
(87) International publication number: WO 2004/090990

(57) **Abstract**

A mesa-type wide-gap semiconductor gate turn-off thyristor has a low gate withstand voltage and a large leakage current. Since the ionization rate of P-type impurities greatly increases at high temperatures when compared with that at room temperature, the hole implantation amount increases and the minority carrier lifetime becomes longer. Consequently, the maximum controllable current is significantly lowered when compared with that at room temperature. To solve these problems, a p-type base layer is formed on an n-type SiC cathode emitter layer which has a cathode electrode on one surface, and a thin n-type base layer is formed can the p-type base layer. A mesa-shaped p-type anode emitter layer is formed in the central region of the n-type base layer. An n-type gate contact region is formed sufficiently apart from the junction between the p-type anode emitter layer and the n-type base layer, and an n-type low-resistance gate region is so formed in the n-type base layer that it surrounds the anode emitter layer.

## Description

### BACKGROUND OF THE INVENTION

The present invention relates to a gate turn-off thyristor that use a wide-gap semiconductor and relates, in particular, to a gate turn-off thyristor capable of interrupting a large current within a wide temperature range.

As a first background art gate turn-off thyristor (hereinafter referred to as GTO) that uses silicon, there is the one disclosed in JP H06-151823 A. In the first background art GTO, a mesa-type p-type base layer is provided on an n-type base layer that has an anode electrode, and an n-type emitter layer is formed by impurity diffusion in a central region of the mesa-type p-type base layer. With this construction, a junction between the p-type base layer and the n-type emitter layer is not exposed on the mesa slope, and therefore, a GTO in which electric field concentration hardly occurs on the mesa slope can be obtained. However, since the n-type emitter layer is formed by impurity diffusion, there are many crystal defects, and the on-resistance of the GTO is increased.

A second background art GTO that uses silicon is disclosed in JP 2692366 B. In the second background art, an n-type base layer is formed on a p-type emitter layer, and a p-type base layer is formed on the n-type base layer. An n-type emitter layer is formed by impurity diffusion on the p-type base layer, and a mesa-type n-type emitter layer is obtained by etching. The second background art is the same as the first background art regarding the point that the n-type emitter layer is formed by impurity diffusion.

As a third background art gate turn-off thyristor (hereinafter abbreviated to GTO) that uses a wide-gap semiconductor such as silicon carbide (SiC), there is, for example, the one described on pages 518 through 520 of the reference document: IEEE Electron Device Letters, Vol. 18, No. 11, November, 1997. In this background art, a p-type anode emitter layer is etched into a mesa-type down to a p-type base layer with which the anode emitter layer is put in contact, and a gate electrode is provided on the base layer so as to surround the anode emitter layer etched into the mesa-type. The structure is presumably adopted for the reasons as follows. In a GTO of silicon (Si) that is not the wide-gap semiconductor, a partial pn junction is generally formed by impurity thermal diffusion or ion implantation. However, in the case of SiC that is the wide-gap semiconductor, the impurity thermal diffusion is very slow and therefore not appropriate for mass production. Therefore, the pn junction is formed by ion implantation. In the case, if high-concentration impurity ions are implanted, the crystal defects increase and the resistance becomes high. Therefore, when a large current is flowed through the GTO, a voltage drop in the region where ions have been implanted increases, and the power loss is large. In particular, when impurity ions of a large atomic radius of a p-type impurity of aluminum or the like are implanted, crystal defects easily occur, and a high-concentration p-type region cannot be formed without a crystal defect. Accordingly, when a partial pn junction is formed at an SiC and particularly when a p-type region that flows a large current is formed, a p-type epitaxial film that has a good crystallinity and a little crystal defect is formed on an n-type layer. A GTO is formed by selectively etching the epitaxial film and forming a mesa-type partial pn junction. An end portion of the junction between the p-type layer and the n-type layer is exposed in the neighborhood of a mesa slope or a mesa corner portion. By covering the entire surface of the GTO after film formation with an insulator, ions from the outside are prevented from adhering to the semiconductor surface, and the long-term reliability of the GTO is secured.

In general, the GTO has a current controllability to effect turn-off by diverting the principal current into the gate by applying a reverse bias voltage between the gate and the anode. Characteristics that represent the controllability include a "maximum controllable current". The maximum controllable current means the maximum current that the GTO can control. In order to increase the maximum controllable current of the GTO, the principal current is diverted into the gate as much as possible by raising the off-gate voltage (reverse voltage applied between the gate and the anode) at the turn-off time. It is known that the maximum controllable current can be increased as the principal current to be diverted into the gate is increased by raising the off-gate voltage.

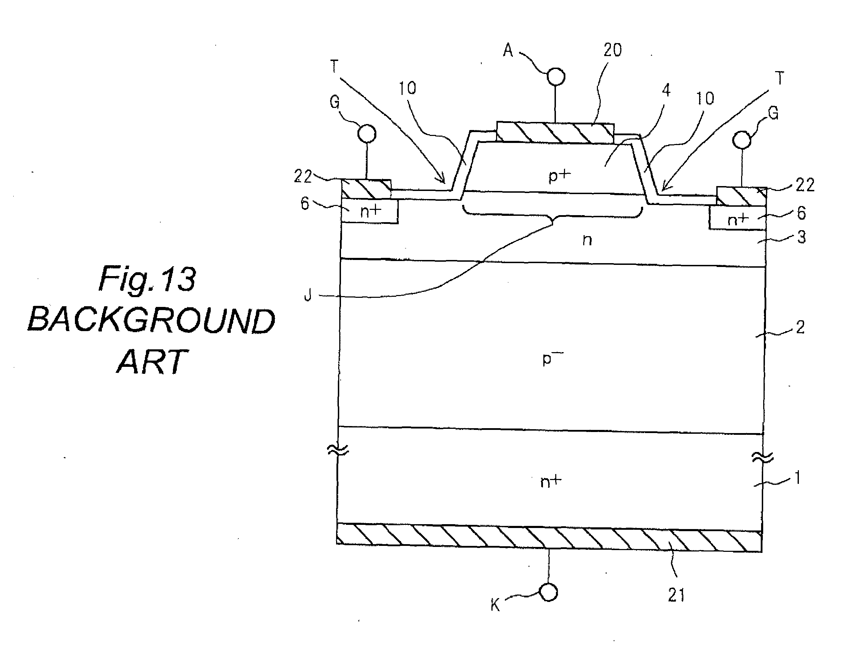

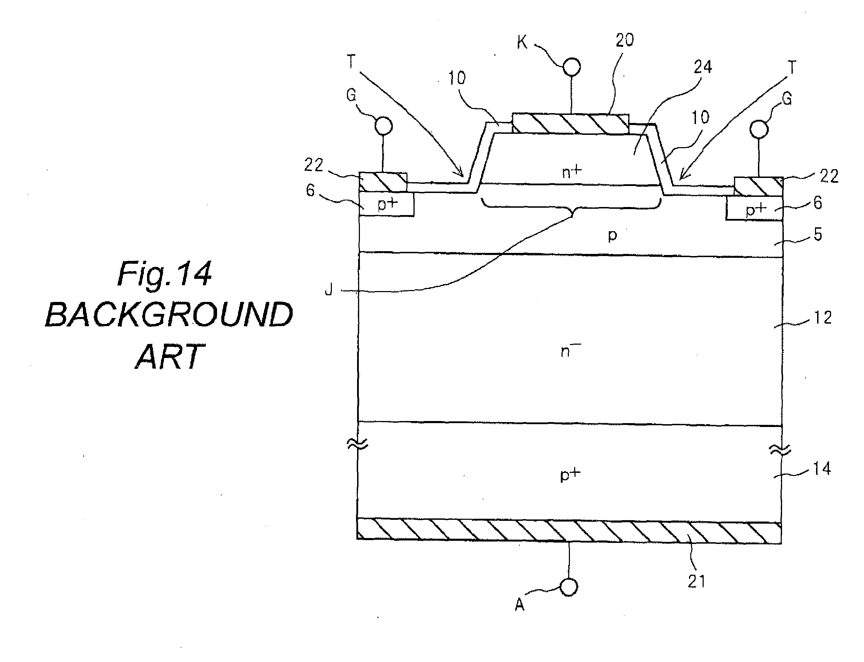

Figs. 13 and 14 show sectional views of typical GTO's of the second and third background art using SiC, respectively. In the second background art GTO shown in Fig. 13, a lightly doped p-type SiC base layer 2 is formed on a heavily doped n-type SiC cathode emitter layer 1 that has a cathode electrode 21 connected to a cathode terminal K (hereinafter referred to as a cathode K) on its lower surface. An n-type base layer 3 is formed on the p-type base layer 2. A p-type layer, a central region of which is left and becomes a p-type anode emitter layer 4 in a subsequent process, is formed by the epitaxial growth method on the entire surface of the n-type base layer 3. Next, the mesa-type anode emitter layer 4 is formed by etching away a region of the p-type layer other than a region that becomes the anode emitter layer 4 by the reactive ion etching method until the surface of the n-type base layer 3 is somewhat removed. An n-type gate contact region 6 is formed by ion implantation so as to surround the anode emitter layer 4 in a portion located apart from a junction J of the end portion of the exposed n-type base layer 3. An anode electrode 20 connected to an anode terminal A (hereinafter referred to as an anode A) is formed on the anode emitter layer 4, and a gate electrode 22 connected to a gate terminal G (hereinafter referred to as a gate G) is formed on the gate contact region 6. Finally, in order to prevent moisture and ions of Na ions and the like from adhering to the surface of the GTO, an insulator 10 of silicon dioxide (SiO₂) or the like is formed on the entire surface excluding the electrodes.

The third background art GTO shown in Fig. 14 has substantially the same construction as that of the GTO shown in Fig. 13 except that the conductive types of the layers and the regions are inverted from those of the GTO shown in Fig. 13.

In the GTO shown in Fig. 13, an off-gate voltage is applied between the gate G and the anode A at the turn-off time. Moreover, in the GTO shown in Fig. 14, an off-gate voltage is applied between the cathode K and the gate G at the turn-off time. As a result, the principal current is diverted into the gate G to turn off the GTO both in the GTO's of Figs. 13 and 14.

If the off-gate voltage is raised in order to increase the maximum controllable current in the GTO of Fig. 13, an electric field at the insulator 10 in the neighborhood of the end region T of the junction J between the anode emitter layer 4 and the n-type base layer 3 is increased. In the case of SiC, the dielectric breakdown field is about ten times that of Si, and therefore, the thickness of the base layer 3 is reduced to several tenths of the thickness of Si. Therefore, if the off-gate voltage is raised, a high electric field is applied to the insulator 10 (e.g., SiO₂ film) on the surface of the mesa that forms the anode emitter layer 4, and this might cause the dielectric breakdown of the insulator 10. Moreover, there is a problem that, if the high electric field is continuously applied for a long term, a leakage current increases to reduce the gate withstand voltage (withstand voltage between the gate G and the anode A) of the GTO element, and the long-term reliability is degraded.

Also, in the GTO of Fig. 14, if the off-gate voltage is raised as a countermeasure for increasing the maximum controllable current, the electric field at the insulator 10 in the neighborhood of the end region T of the junction J between the cathode emitter layer 24 and the base layer 5 is increased. Consequently, the withstand voltage between the cathode K and the gate G is lowered, and the long-term reliability is degraded.

As another countermeasure for increasing the maximum controllable current, a method for reducing the resistance in the transverse direction by increasing the impurity concentration of the base layer on which the gate electrode is provided and a method for increasing the thickness of the base layer are described in JP S61-182260 A. If the resistance in the transverse direction of the base layer is reduced by increasing the impurity concentration, the implantation efficiency of carriers (e.g., holes in the case of the GTO of Fig. 13 or electrons in the case of the GTO of Fig. 14) implanted from the emitter layer located adjacent to the base layer at the time of turning on the GTO is reduced. Moreover, if the base layer on which the gate is provided is increased in thickness, the amount of carriers, which move from the adjacent emitter layer through the base layer to the underlying base layer, is reduced. As a result, a gate current necessary for turning on the GTO is increased. Moreover, the on-state voltage is also raised, which causes a problem that the power loss is increased.

The maximum junction temperature during the use of a semiconductor device that uses a wide-gap semiconductor is significantly higher than the maximum junction temperature (about 125°C) during the use of a semiconductor that uses an Si semiconductor. For example, the maximum junction temperature during the use of SiC is not lower than 500°C. Therefore, in a device that uses a wide-gap semiconductor, the semiconductor device should preferably maintain the desired characteristics within a wide temperature range from room temperature to a temperature of not lower than 500°C.

According to a background art reference of Material Science Forum Vols. 389-393 (2002), pp. 1349-1352, it is disclosed that the maximum controllable current is significantly reduced when the use temperature becomes 150°C or higher in the GTO of SiC. For example, at a temperature of 200°C, the maximum controllable current is reduced to about one sixth or less of the maximum controllable current at room temperature- This is presumably for the reasons as follows.

For the sake of easy understanding, the case of the GTO of Si is described first. In the case of si, boron or aluminum is used as an acceptor. The substances have shallow acceptor levels of 45 meV and 60 meV and are easily ionized at room temperature, generating holes from the acceptor. Therefore, almost all the impurities are ionized, generating holes. When Si is used at a temperature up to the maximum junction temperature of 125°C, the ionization rate scarcely poses a problem since the impurity ionization rate is sufficiently high.

Boron and aluminum, which are also used as an acceptor in the case of GTO of SiC as in the case of GTO of Si, have deep acceptor levels of about 300 meV and about 240 mV, respectively, and a low ionization rate of not higher than several percent at room temperature. However, the ionization rate is significantly increased when the temperature is elevated.

For example, in the GTO of Fig. 13, when the temperature is elevated to 150°C or higher and the ionization rate of the p-type anode emitter layer 4 is increased, the number of holes implanted into the p-type base layer 2 from the anode emitter layer 4 via the n-type base layer 3 becomes significantly greater than at room temperature. Moreover, since electrons are also increased and the excess carriers (holes and electrons) are increased in the p-type base layer 2, the maximum controllable current is reduced. Furthermore, since the carrier lifetime also becomes longer at a high temperature of not lower than 150°C, the maximum controllable current is also significantly reduced by this. Moreover, since the carrier density in the p-type anode emitter layer 4 is increased at high temperature, the depletion layer does not sufficiently spread when the off-gate voltage is applied. In such a state, the electric field is increased in the neighborhood of the end region T of the anode emitter layer 4 in the neighborhood of the junction J between the p-type anode emitter layer 4 and the n-type base layer 3, and the withstand voltage (about 30 V) between the anode A and the gate G is lowered.

Moreover, if the GTO of Fig. 14 enters a state as described above, the withstand voltage (about 30 V) between the cathode K and the gate G is lowered. Furthermore, the electric field in the neighborhood of the end region T of the cathode emitter layer 24 is increased, and the electric field of the insulator 10 is increased, possibly causing dielectric breakdown. Moreover, the leakage current is increased, and this reduces the reliability during long-term use.

### SUMMARY OF THE INVENTION

According to the present invention, in the gate turn-off thyristor (hereinafter referred to as a wide-gap GTO) of a wide-gap semiconductor that has a mesa-type emitter layer, the maximum controllable current is increased by relieving the electric field of the insulator located in the neighborhood of the end portion of the junction between an emitter layer and a base layer where a gate is provided adjacent to the emitter layer.

In order to relieve the electric field of the insulator located in the neighborhood of the end portion of the junction, a low-resistance gate region of a low resistance value is formed in the base layer. With this arrangement, a current at the turn-off time flows through the low-resistance gate region of a low resistance value, and therefore, a voltage drop is a little. If the gate current is increased at the turn-off time by raising the off-gate voltage, the electric field of the insulator is not increased so much. As another method for preventing the increase in the electric field of the insulator, there is a method for forming a field relief region in the neighborhood of the junction. Since the electric field of the insulator is relieved by the method, the off-gate voltage can be raised. Therefore, the principal current can be diverted with high efficiency. Since the off-gate voltage can be raised, a large maximum controllable current can be maintained within a wide temperature range from a low temperature of not higher than room temperature to an elevated temperature that exceeds 500°C. When the off-gate voltage is not increased so much, the long-term reliability is remarkably improved. Since the electric field of the insulator in the neighborhood of the junction can be reduced, the long-term reliability of the GTO can be maintained.

A gate turn-off thyristor of a wide-gap semiconductor of the present invention includes a first emitter layer of either one of n-type and p-type conductive types having a first electrode on its one surface and a first base layer of a conductive type different from that of the first emitter layer provided on the other surface of the first emitter layer. This gate turn-off thyristor further includes a second base layer of a conductive type identical to that of the first emitter layer provided on the first base layer, a mesa-type second emitter layer of a conductive type different from that of the first emitter layer provided on the second base layer and a second electrode provided on the mesa-type second emitter layer. A low-resistance gate region is provided so as to surround the mesa-type second emitter layer in a region located apart from an end portion of a junction between the mesa-type second emitter layer and the second base layer, formed in a region that extends from a neighborhood of the end portion of the junction to a bottom portion of the mesa-type second emitter layer with interposition of the second base layer between the region and the junction, and having a conductive type identical to that of the second base layer and an impurity concentration higher than that of the second base layer. A third electrode is put in contact with an end portion of the low-resistance gate region.

According to the present invention, by virtue of the first conductive type low-resistance gate region formed in the first conductive type base layer, an electron current flows from the first conductive type base layer through the first conductive type low-resistance gate region and the first conductive type gate contact region to the gate at the turn-off time. Since the low-resistance gate region has a low resistance value, a voltage drop in the first conductive type base layer is small even when a current due to the electron flow is large. Therefore, the off-gate voltage applied between the anode and the gate is not influenced by the voltage drop, and a large current can be flowed with high efficiency. As a result, the controllable current of the GTO can be increased.

In another aspect of the present invention, a gate turn-off thyristor of a wide-gap semiconductor includes a first emitter layer of either one of n-type and p-type conductive types having a first electrode on its one surface and a first base layer of a conductive type different from that of the first emitter layer provided on the other surface of the first emitter layer. This GTO further includes a second base layer of a conductive type identical to that of the first emitter layer provided on the first base layer and a mesa-type second emitter layer of a conductive type different from that of the first emitter layer provided on the second base layer. This GTO further includes a second electrode, which is put in contact with a central region of the mesa-type second emitter layer and put in contact with the second emitter layer via a contact electrode in a region excluding the central region of the second emitter layer. In a region located apart from the end portion of the junction between the mesa-type second emitter layer and the second base layer, a low-resistance region, which has a conductive type identical to that of the second base layer and an impurity concentration higher than that of the second base layer, is provided so as to surround the mesa-type second emitter layer. A third electrode is provided in contact with the end portion of the low-resistance region.

In another aspect of the present invention, a gate turn-off thyristor of a wide-gap semiconductor includes a first emitter layer of either one of n-type and p-type conductive types having a first electrode on its one surface, a first base layer of a conductive type different from that of the first emitter layer provided on the other surface of the first emitter layer, a second base layer of a conductive type identical to that of the first emitter layer provided on the first base layer, a mesa-type second emitter layer of a conductive type different from that of the first emitter layer provided on the second base layer, a high-resistance region provided in a central region of an upper surface of the second emitter layer and having a conductive type identical to that of the second emitter layer and an impurity concentration lower than that of the second emitter layer, a contact electrode put in contact with the second emitter layer and the high-resistance region, a second electrode put in contact with the contact electrode and the second emitter layer at least at a peripheral portion of the contact electrode, and having a contact resistance to the emitter layer greater than a contact resistance of the contact electrode to the emitter layer, a low-resistance region provided so as to surround the mesa-type second emitter layer in a region located apart from an end portion of a junction between the mesa-type second emitter layer and the second base layer, and having a conductive type identical to that of the second base layer and an impurity concentration higher than that of the second base layer, and a third electrode put in contact with an end portion of the low-resistance region.

According to the present invention, the second electrode is put in contact with only the central region of the second emitter layer and put in contact with the second emitter layer via the contact electrode formed of a material of which the contact resistance to the semiconductor layer is lower than that of the second electrode in the other region. Therefore, the contact resistance between the second electrode and the second emitter layer in the region located with interposition of the contact electrode is lower than that of the other region. With this arrangement, a current that flows from the second electrode into the second emitter layer flows more in the peripheral region located with interposition of the contact electrode than in the central region where the resistance is relatively high. In the GTO, the current control effect by virtue of the low-resistance region is great in a portion located near the low-resistance region, but the effect is reduced in the central region remote from the low-resistance region. In the present invention, the greater part of the electrification current is flowed in the peripheral region where the current control effect by virtue of the low-resistance region is high, so that the current in the central region of a low control effect is reduced. As a result, the efficiency of extracting a current from the gate at the turn-off time is increased, and therefore, the controllable current of the GTO is increased.

According to the present invention, by sufficiently separating the gate contact region of the GTO that uses a wide-gap semiconductor from the junction between the mesa-type emitter layer and the base layer, the electric field in the neighborhood of the junction or in the neighborhood of the mesa corner portion is not increased even when the off-gate voltage is high. By raising the off-gate voltage, the current flowing between the anode and the cathode can efficiently be diverted into the gate, and the controllable current of the GTO can be increased. Moreover, since a high electric field is not applied to the insulator, the leakage current is not increased, and the long-term reliability can be maintained.

By forming the low-resistance region adjacent to the gate contact region, a voltage drop caused by the current that flows through the low-resistance region at the turn-off time can be reduced. Therefore, even when the off-gate voltage is the same as the conventional one, the turn-off current can be diverted into the gate with higher accuracy than in the conventional GTO. Even if the p-type impurity ionization rate is increased than at room temperature or the carrier lifetime become longer during use at high temperature, the off-gate voltage can be raised. Furthermore, the gate current at the turn-off time can be diverted into the gate with high efficiency by the low-resistance region. Therefore, a GTO, which has a large controllable current within a wide temperature range from a low temperature of not higher than room temperature to a temperature that exceeds 500°C and is able to maintain high reliability for a long term, can be provided.

### BRIEF DESCRIPTION OF THE DRAWINGS

Fig. 1 is a top view of a gate turn-off thyristor of a first embodiment of the present invention;
Fig. 2 is a sectional view of the gate turn-off thyristor of the first embodiment of the present invention;
Fig. 3 is a sectional view of the gate turn-off thyristor of the second embodiment of the present invention;
Fig. 4 is a sectional view of the gate turn-off thyristor of the third embodiment of the present invention;
Fig. 5 is a sectional view of the gate turn-off thyristor of the fourth embodiment of the present invention;
Fig. 6 is a sectional view of the gate turn-off thyristor of the fifth embodiment of the present invention;
Fig. 7 is a sectional view of the gate turn-off thyristor of the sixth embodiment of the present invention;
Fig. 8 is a sectional view of the gate turn-off thyristor of the seventh embodiment of the present invention;
Fig. 9 is a sectional view of the gate turn-off thyristor of the eighth embodiment of the present invention;
Fig. 10 is a sectional view of the gate turn-off thyristor of the ninth embodiment of the present Invention;
Fig. 11 is a sectional view of the gate turn-off thyristor of the tenth embodiment of the present invention;
Fig. 12 is a sectional view of the gate turn-off thyristor of the eleventh embodiment of the present invention;
Fig. 13 is a sectional view of a background art gate turn-off thyristor; and
Fig. 14 is a sectional view of another background art gate turn-off thyristor.

### DETAILED DESCRIPTION OF THE INVENTION

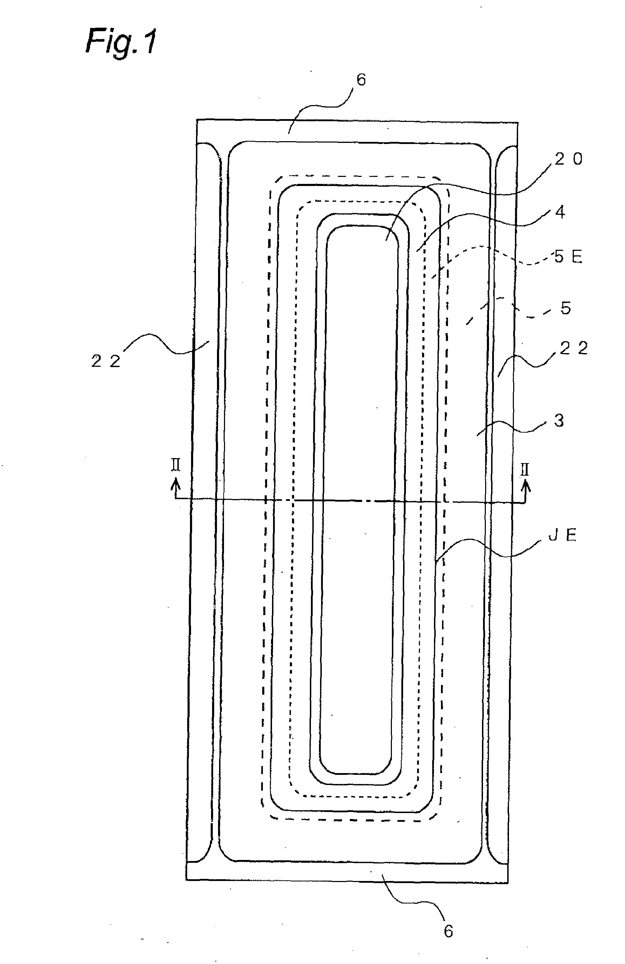

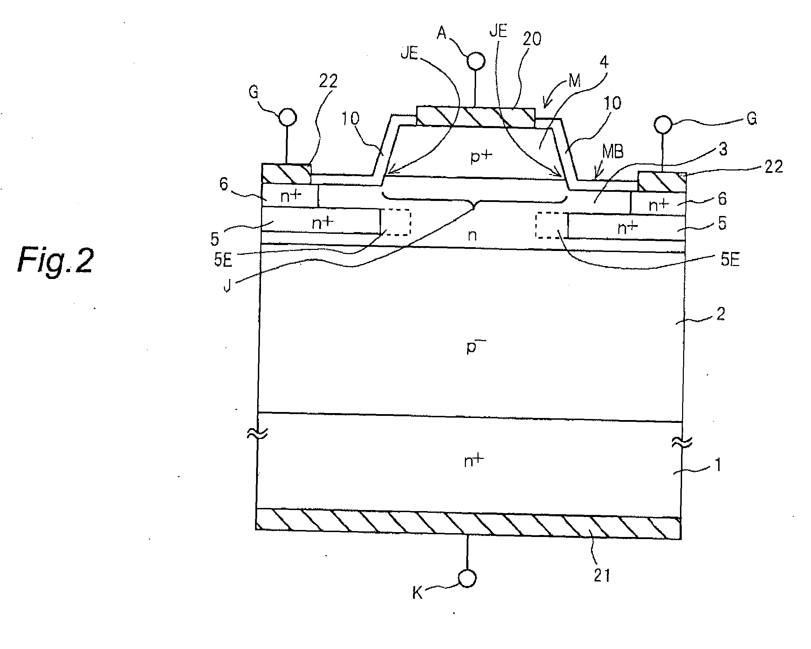

Preferred embodiments of the gate turn-off thyristor (hereinafter, abbreviated to GTO) that uses silicon carbide (hereinafter, SiC) of the present invention will be described with reference to Figs. 1 through 12. Fig. 1 is a top view of one element of the GTO of the first embodiment of the present invention. Figs. 2 through 8 are sectional views of one element (unit) of the GTO of each embodiment of the present invention. No hatching is shown in the cross sections of the figures for the sake of clear views of the figures. The top views of the GTO's of the embodiments are basically similar to the one shown in Fig. 1. In the actual construction of the GTO of each of the embodiments, a number (normally several tens to several thousands) of elements are connected together on an identical substrate horizontally in the figure, and the anode electrodes, gate electrodes and cathode electrodes are connected parallel or in series depending on the situation. Although not shown in the figures, it is general that a number of elements are horizontally arranged and a number of elements are also arranged in columns in the vertical direction in the figures.

### FIRST EMBODIMENT

A GTO that uses SiC of the first embodiment of the present invention is described with reference to Figs. 1 and 2. Fig. 1 is a top view that shows the upper surface before the provision of an insulator 10 of the GTO of the first embodiment. Fig. 2 is a sectional view taken along the line II-II of Fig. 1. In Figs. 1 and 2, the GTO of the present embodiment has a heavily doped cathode emitter layer 1 (first emitter layer) of an n-type (first conductive type) SiC semiconductor that has a thickness of about 350 µm and an impurity concentration of not smaller than about 10¹⁹ cm⁻³ and is provided with a cathode electrode 21 (first electrode) connected to the cathode terminal K (cathode K, hereinafter). A lightly doped base layer 2 (first base layer) of a p-type (second conductive type) SiC semiconductor that has a thickness of 50 µm and an impurity concentration of about 10¹⁶ to 10¹³ cm⁻³ is formed on the cathode emitter layer 1. A thin n-type base layer 3 (second base layer) of a thickness of several micrometers is formed on the p-type base layer 2. A p-type layer that serves as a p-type anode emitter layer 4 is grown by the epitaxial growth method on the entire surface of the n-type base layer 3 leaving a central region in a subsequent process. Next, a mesa-type anode emitter layer 4 is formed by deeply etching the other region by the reactive ion etching method to an extent that the surface of the n-type base layer 3 is exposed and its surface portion is somewhat removed leaving a region that becomes the p-type anode emitter layer 4 (second emitter layer). By implanting ions into the exposed surface n-type base layer 3, an n-type low-resistance gate region 5 and an n-type gate contact region 6 are successively formed so as to surround the anode emitter layer 4. The impurity concentration of the low-resistance gate region 5 should preferably be three times the impurity concentration of the base layer 3. The low-resistance gate region 5 may be formed down to the neighborhood of the upper surface of the base layer 2 in the ion implantation process. The low-resistance gate region 5 is formed slightly apart from the junction J between the anode emitter layer 4 and the base layer 3. The gate contact region 6 is a low-resistance region of an impurity concentration higher than that of the low-resistance gate region 5 and is formed in a position located far apart from the junction J. An anode electrode 20 (second electrode) connected to an anode terminal A (anode A, hereinafter) is formed on the anode emitter layer 4, and a gate electrode 22 (third electrode) connected to a gate terminal G (gate G, hereinafter) is formed on the gate contact region 6. Finally, in order to prevent moisture and ions of Na ions and the like from adhering to the surface of the GTO after the formation of the layers, an insulator 10 of silicon dioxide (SiO₂) or the like is formed on the entire surface excluding the electrodes. Nitrogen can be used as an n-type impurity. Moreover, boron and aluminum can be used as a p-type impurity.

The structural feature of the GTO of the present embodiment resides in that the n-type gate contact region 6 in the n-type base layer 3 is separated from the junction J between the p-type anode emitter layer 4 and the n-type base layer 3, providing a large creeping distance. Another feature resides in that the low-resistance gate region 5 that has a low resistance value and a high n-type impurity concentration is formed in the n-type base layer 3 and separated a prescribed distance apart from the junction J between the p-type anode emitter layer 4 and the n-type base layer 3 in the direction of the base layer 2. A distance between the n-type gate contact region 6 and an end portion JE of the junction J between the p-type anode emitter layer 4 exposed on the slope of the mesa M and the n-type base layer 3 is about 2 µm to 10 µm. Moreover, the n-type low-resistance gate region 5 is formed at a depth of about 0.3 µm to 5 µm from the upper surface of the n-type base layer 3.

In the present embodiment, as shown in Fig. 2, the n-type low-resistance gate region 5 should preferably be formed only below the bottom surface MB of the mesa M. However, it is acceptable to extend a little the n-type low-resistance gate region 5 to the inside of the n-type base layer 3 below the p-type anode emitter layer 4 as indicated by an extension 5E in Fig. 2. Extending the low-resistance gate region 5 toward the extension 5E increases the maximum controllable current, the minimum firing current and the on-state voltage of the GTO and lowers the withstand voltage. Conversely, making the low-resistance gate region 5 shorter than the length shown in Fig. 2 reduces the maximum controllable current, the minimum firing current and the on-state voltage of the GTO and raises the withstand voltage. Particularly, when a high withstand voltage is required, it is preferable to shorten the n-type low-resistance gate region 5 and separate the region from the anode emitter layer 4.

Operation of the GTO of the present embodiment is described below. If a forward bias voltage is applied between the anode A and the gate G by making the voltage of the gate G lower than the voltage of the anode A in a state in which the voltage of the anode A is higher than the voltage of the cathode K, then a current flows from the anode A to the gate G. In this state, holes are injected from the anode emitter layer 4 into the n-type base layer 3 and enter the p-type base layer 2, while electrons are injected from the n-type cathode emitter layer 1 into the p-type base layer 2, consequently turning on the GTO and putting it into the on-state. If a reverse bias voltage is applied between the anode A and the gate G, an electron current that flows from the cathode K to the anode A is diverted into the gate G, then the GTO is turned off.

In the GTO of the present embodiment, the n-type gate contact region 6 is located apart from the junction J between the mesa-type p-type anode emitter layer 4 and the n-type base layer 3. Therefore, the withstand voltage between the gate G and the anode A is not determined by the creeping distance between the two but determined by the dielectric breakdown field originally possessed by SiC in the p-type anode emitter layer 4. Since SiC has a high dielectric breakdown field, the GTO of the present embodiment has a high withstand voltage. Moreover, even when the ionization rate of the p-type anode emitter layer 4 is increased and the hole concentration is increased at an elevated temperature, the high withstand voltage can be maintained.

By virtue of the formation of the n-type low-resistance gate region 5 in the n-type base layer 3, an electron current flows from the n-type base layer 3 to the gate G through the n-type low-resistance gate region 5 and the n-type gate contact region 6 at the turn-off time. Since the n-type low-resistance gate region 5 has a high impurity concentration and a low resistance value, the voltage drop in the n-type base layer 3 is small and the electric field applied to the insulator 10 in the neighborhood of the junction J is not increased even when the electron current is large. Therefore, the off-gate voltage applied between the anode A and the gate G is not influenced so much by the voltage drop, and the off-gate voltage can be raised. By raising the off-gate voltage, a large electron current can be flowed with high efficiency. As a result, the controllable current of the GTO of the present embodiment can be increased. When the GTO of the present embodiment is used at a high temperature of about 500°C, the maximum controllable current can be increased by raising the off-gate voltage in the GTO of the present embodiment even when the amount of holes injected into the n-type base layer 3 is increased as a consequence of an increase in the hole concentration of the p-type anode emitter layer 4 or when the lifetime of holes and electrons become longer due to the temperature rise. Since the electric field applied to the insulator in the neighborhood of the junction J can be reduced, long-term reliability can be maintained.

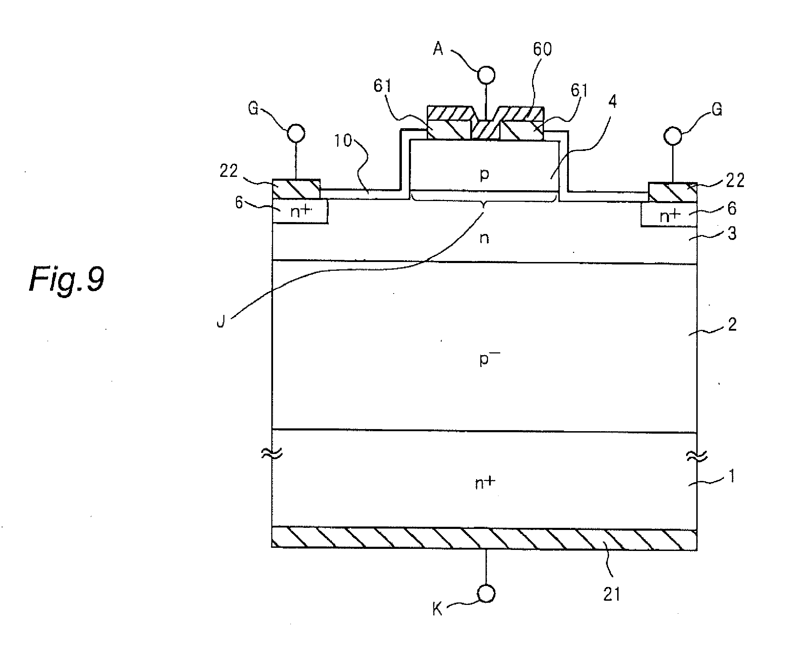

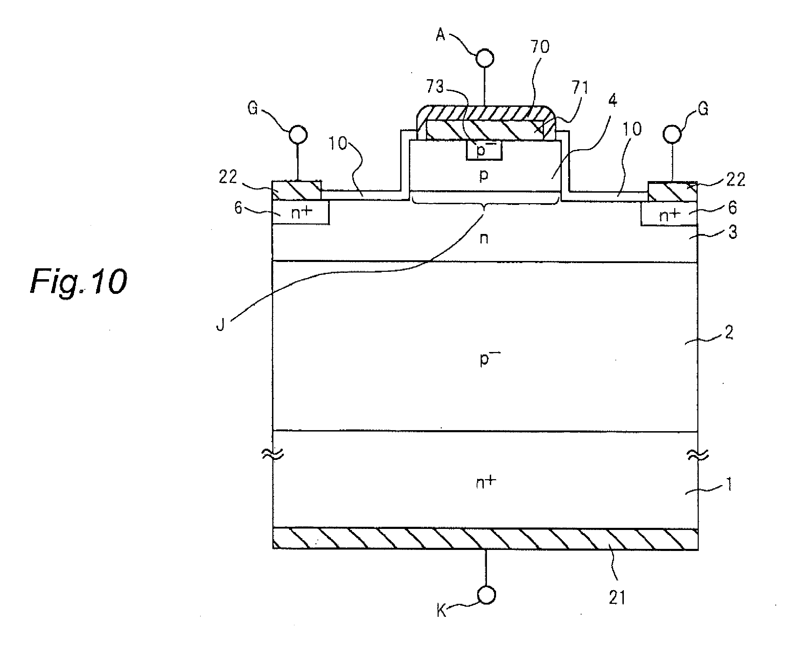

In a concrete example of the GTO of the present embodiment, the withstand voltage between the gate G and the anode A was 150 V, which means that a remarkable rise in the withstand voltage was able to be achieved in comparison with the voltage of about 30 V of the GTO of the background art examples shown in Figs. 9 and 10. No high electrical field is applied to the insulator 10 in the neighborhood of the junction J even when the gate voltage at the turn-off time is raised to increase the maximum controllable current, and dielectric breakdown is hard to occur. Since no high electrical field is applied, a decrease of the withstand voltage between the gate G and the anode A induced by an increase in the leakage current between the gate G and the anode A does not arise, and high reliability can be maintained for a long term.

In the present embodiment, the anode emitter layer 4 is formed by the epitaxial growth method. Since crystal defects are very little by the epitaxial growth method, holes can sufficient be injected into the n-type base layer 3. Therefore, the on-state voltage is reduced to a low voltage of 3.7 V, and the loss can be reduced. For example, when an anode emitter layer was formed by the ion implantation method causing many crystal defects, the on-state voltage was 7.5 V.

Although an angle of the slope of the mesa-type anode emitter layer 4 with respect to the surface of the base layer 3 is about 105 degrees in the example shown in Fig. 2, the present invention is applicable when the angle is within a range of about 140 degrees to 55 degrees.

### SECOND EMBODIMENT

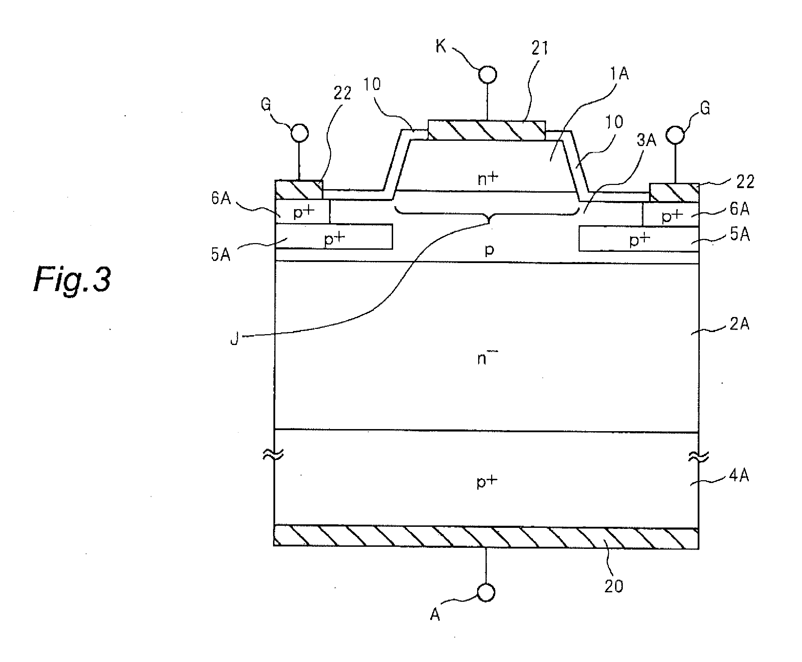

Fig. 3 is a sectional view of a GTO that uses SiC of the second embodiment of the present invention. In Fig. 3, the p-type and the n-type of the layers are interchanged in the GTO of the present embodiment in comparison with the GTO of the first embodiment shown in Fig. 2. A lightly doped n-type SiC base layer 2 (second base layer) that has a thickness of about 50 µm is formed on the upper surface of a p-type anode emitter layer 4A (first emitter layer) that has a thickness of about 350 µm and is provided with an anode electrode 20 (first electrode) connected to the anode A on its lower surface. A thin p-type base layer 3A (second base layer) that has a thickness of several micrometers is formed on the base layer 2A, and an n-type layer of which central region is left in a subsequent process to serve as an n-type cathode emitter layer 1A is formed by the epitaxial growth method on the entire surface of the p-type base layer 3A. Next, a region is deeply etched by the reactive ion etching method to an extent that the surface of the p-type base layer 3A is exposed and its surface portion is somewhat removed leaving the other region that becomes the cathode emitter layer 1A (second emitter layer) of the n-type layer, forming the mesa-type cathode emitter layer 1A. Then, the cathode electrode 21 (second electrode) is formed on the cathode emitter layer 1A. A low-resistance gate region 5A that has a p-type high impurity concentration by ion implantation and a low resistance and a p-type gate contact region 6A are formed successively layered on the exposed p-type base layer 3A so as to surround the cathode emitter layer 1A. A gate electrode 22 (third electrode) is formed on the gate contact region 6A. Finally, an SiO₂ insulator 10 is formed on the entire surface excluding the electrodes.

In the GTO of the present embodiment, the gate electrode 22 and the cathode electrode 21 are adjacently located. Therefore, if a forward bias voltage is applied between the cathode K and the gate G in a state in which the voltage of the anode A is higher than the voltage of the cathode K, then a current flows from the gate G to the cathode K. As a result, holes are injected from the anode emitter layer 4A into the n-type base layer 2A and enters the p-type base layer 3, while electrons are injected from the n-type cathode emitter layer 1A into the p-type base layer 3A, by which the GTO is turned on and put into the on-state. If a reverse bias voltage is applied between the cathode K and the gate G to divert the current that flows from the anode A to the cathode K into the gate G, then the GTO is turned off.

In the GTO that uses SiC of the present embodiment, by virtue of the formation of the n-type low-resistance gate region 5A in the p-type base layer 3A, the current that flows from the anode A to the gate G at the turn-off time passes through the low-resistance gate region 5A and the gate contact region 6A. Since the low-resistance gate region 5A has a low resistance value, a voltage drop is small, and a large current can be flowed through the gate G. Therefore, by operation substantially similar to that of the first embodiment, the electric field of the insulator 10 in the neighborhood of the junction J between the n-type cathode emitter layer 1A and the p-type base layer 3A can be reduced at the turn-off time and in the off-state. Moreover, by raising the off-gate voltage at the turn-off time, almost the same maximum controllable current as that at room temperature can be obtained even at an elevated temperature.

### THIRD EMBODIMENT

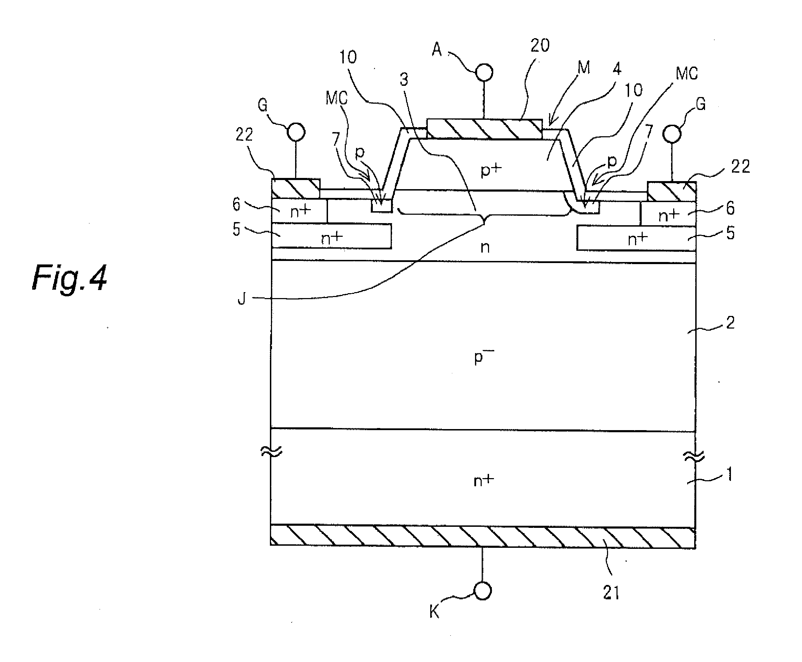

Fig. 4 is a sectional view of a GTO that uses SiC of the third embodiment of the present invention. In the GTO of the present embodiment shown in the figure, a p-type region 7, which includes at least the neighborhood of the end portion of the junction J between the p-type anode emitter layer 4 and the n-type base layer 3 and expands from the neighborhood of a corner portion MC of the mesa M toward the gate electrode 22, is formed in the n-type base layer 3. The other construction is the same as that of the GTO of the first embodiment shown in Fig. 2. By virtue of the formation of the p-type region 7, the field intensity of the insulator 10 in the neighborhood of the mesa corner portion MC located at the end portion of the junction J between the p-type anode emitter layer 4 and the n-type base layer 3 can be relieved even when the off-gate voltage at the turn-off time is increased. As a result, the withstand voltage between the gate G and the anode A can be raised, and the controllable current can be increased. Moreover, since the intensity of the electric field applied to the insulator 10 can be reduced, the deterioration of the insulator 10 can be prevented. Therefore, an increase in the leakage current between the gate G and the anode A is not caused even during a long-term use, and high reliability can be maintained for a long term. In the concrete example of the GTO of the present embodiment, the withstand voltage between the gate G and the anode A was 205 V, which means that a withstand voltage higher than the withstand voltage (150 V) of the GTO of the first embodiment was able to be obtained.

### FOURTH EMBODIMENT

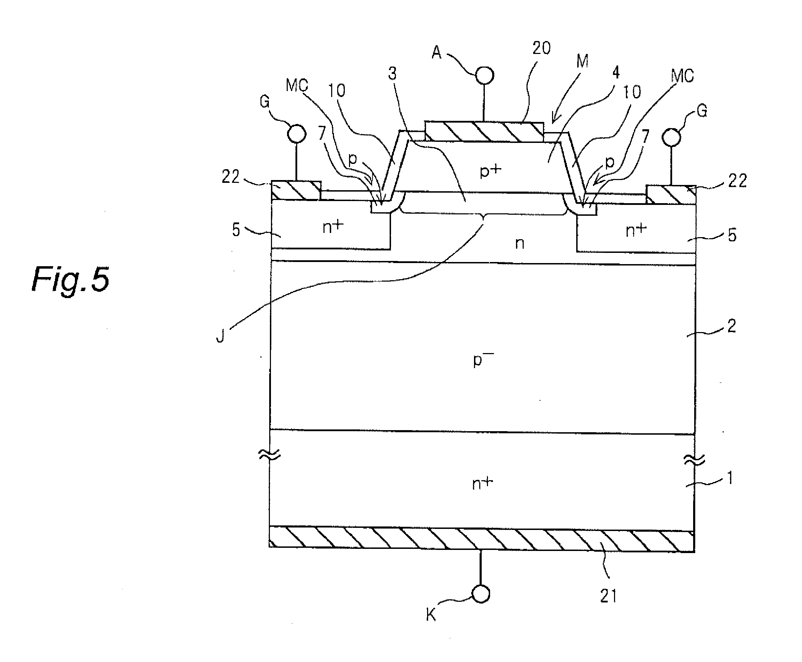

Fig. 5 is a sectional view of a GTO that uses SiC of the fourth embodiment of the present invention. In the GTO of the present embodiment shown in the figure, the n-type low-resistance gate region 5 is provided in a portion of an end region of the n-type base layer 3 excluding the p-type anode emitter layer 4. The n-type low-resistance gate region 5 is formed by self-alignment in the n-type base layer 3 by means of a mask for mesa etching for forming the p-type anode emitter layer 4. Therefore, a process for forming the pattern of the n-type low-resistance gate region 5 can be eliminated. In the present embodiment, as in the third embodiment, a p-type region 7, which includes at least the neighborhood of the end portion of the junction J between the p-type anode emitter layer 4 and the n-type base layer 3 and expands from the neighborhood of the corner portion MC of the mesa M to the gate electrode 22, is formed in the n-type low-resistance gate region 5. The other construction is the same as that of the first embodiment shown in Fig. 2. The formation of the p-type region 7 prevents the formation of a junction between the heavily doped p-type anode emitter layer 4 and the heavily doped n-type low-resistance gate region 5 in the neighborhood of the mesa corner portion MC and forms a junction at the bottom surface of the mesa M. As a result, the field intensity of the insulator 10 in the neighborhood of the mesa corner portion MC is relieved, and the off-gate voltage can be raised. It is also acceptable to enlarge the p-type region 7 so that the region covers the mesa corner portion MC and form the region connected to the anode emitter layer 4. According to the concrete example of the present embodiment, the withstand voltage between the gate G and the anode A was 130 V, which means that a withstand voltage remarkably higher than the withstand voltage (about 30 V) of the conventional GTO was able to be obtained although the withstand voltage is lower than the withstand voltage (150 V) of the GTO of the first embodiment. Since the withstand voltage is high, the controllable current can be increased by raising the gate voltage. In the GTO of the present fourth embodiment, the gate contact region 6A, which is provided in the GTO of each of the first through third embodiments, is not provided. Therefore, the construction is simple, and the manufacturing cost is low.

### FIFTH EMBODIMENT

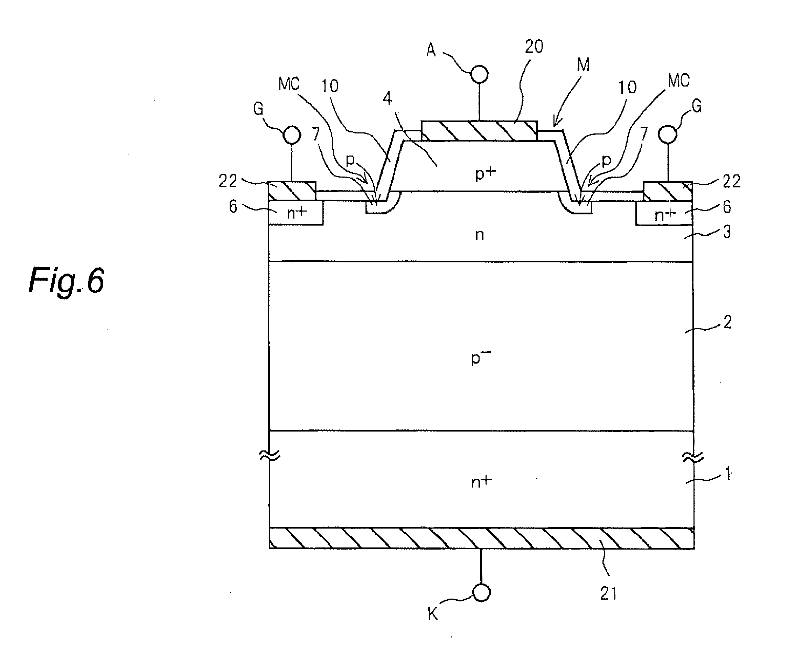

Fig. 6 is a sectional view of a GTO that uses SiC of the fifth embodiment of the present invention. In Fig. 6, the GTO of the present embodiment has a construction in which the n-type low-resistance gate region 5 is excluded from the GTO of the third embodiment shown in Fig. 4. In a process for forming the n-type low-resistance gate region 5 in the GTO of the third embodiment, a heavily doped n-type layer is formed by carrying out ion implantation into the n-type base layer 3. At this time, crystal defects easily occur in the n-type base layer 3 and the n-type low-resistance gate region 5. As a result, a leakage current on a surface between the gate and the anode is increased. Since the n-type low-resistance gate region 5 is not provided in the present embodiment, the problem caused by the crystal defects does not occur in the n-type base layer 3.

As in the GTO of the third embodiment shown in Fig. 4, in the present embodiment, a p-type region 7, which includes at least the neighborhood of the end portion of the junction J between the p-type anode emitter layer 4 and the n-type base layer 3 and expands from the neighborhood of the corner portion MC of the mesa M toward the gate electrode 22 for relieving the field intensity, is formed in the n-type base layer 3. As in the case of the fourth embodiment, also in the present embodiment, it is acceptable to enlarge the p-type region 7 so that the region covers the mesa corner portion MC and is connected to the anode emitter layer 4. With this construction, the field intensity in the neighborhood of the mesa corner portion MC is not increased even if the off-gate voltage is raised, and therefore, the field intensity of the insulator 10 is not increased. Therefore, the deterioration of the insulator 10 is avoided. In a concrete example of the GTO of the present embodiment, the withstand voltage between the gate electrode 22 and the anode electrode 21 was 210 V. Since the off-gate voltage can be raised, a GTO of a large controllable current can be provided.

### SIXTH EMBODIMENT

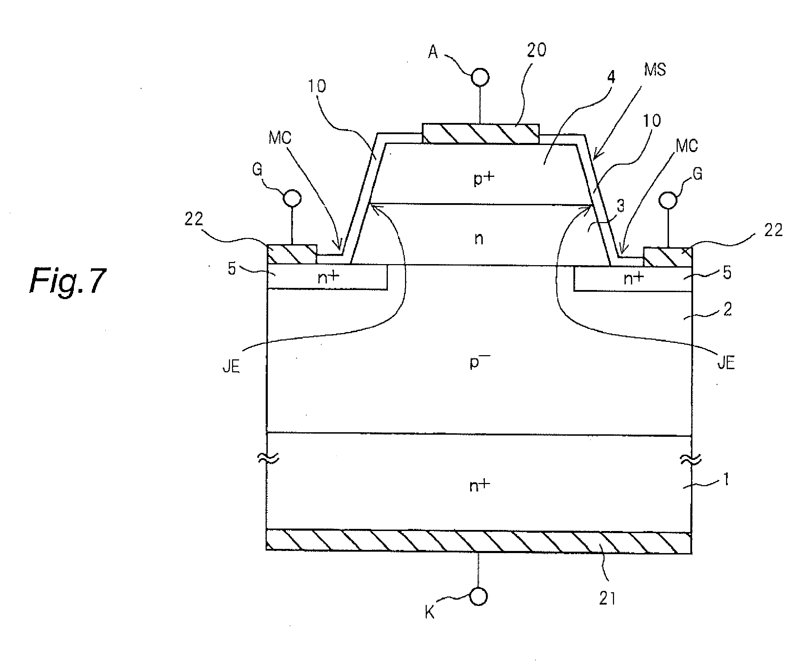

Fig. 7 is a sectional view of a GTO that uses SiC of the sixth embodiment of the present invention. In the GTO of the present embodiment, a p-type base layer 2 is formed by the epitaxial growth method on a heavily doped n-type SiC cathode emitter layer 1 provided with a cathode electrode 21 on its lower surface. Next, an n-type low-resistance gate region 5 is formed in both end regions of the p-type base layer 2. Next, an n-type base layer and a p-type anode emitter layer, which become the n-type base layer 3 and the p-type anode emitter layer 4, respectively, through a subsequent process, are successively layered by the epitaxial growth method on the entire surfaces of the p-type base layer 2 and the n-type low-resistance gate region 5, respectively. Both the end regions of the n-type base layer and the p-type anode emitter layer are etched by the reactive ion etching method until the surface of the n-type low-resistance gate region 5 is exposed, forming the mesa-type n-type base layer 3 and p-type anode emitter layer 4 that have a mesa slope MS. According to the construction of the present embodiment, a junction JE exposed on the mesa slope MS of the p-type anode emitter layer 4 and the n-type base layer 3 is separated from the neighborhood of the mesa corner portion MC where electric field concentration easily occurs, allowing a sufficient creeping distance to be provided. Therefore, since the off-gate voltage can be raised, a GTO of a large controllable current can be provided. When the n-type low-resistance gate region 5 is formed in the n-type base layer 3 by implanting ions to a deep portion in the base layer 3 as in the cases of the first through fourth embodiments, crystal defects easily occur in the n-type base layer 3. In contrast to this, when the n-type base layer 3 is formed by the reactive etching method, no crystal defect occurs in the n-type base layer 3. Since the ion implantation is carried out only in forming the n-type low-resistance gate region 5 in the p-type base layer 2, ion implantation processes are few, and the manufacturing processes of the GTO can be simplified.

In the case of the GTO of SiC, the impurity concentration of the n-type base layer 3 is higher than in, for example, the GTO of Si. Therefore, a depletion layer does not spread so much in the n-type base layer 3 at the turn-off time. Therefore, the electric field concentration on the end portion of the low-resistance gate region, which causes a problem in the GTO of Si, does not occur. Therefore, the withstand voltage between the anode electrode 20 and the cathode electrode 21 can be raised.

### SEVENTH EMBODIMENT

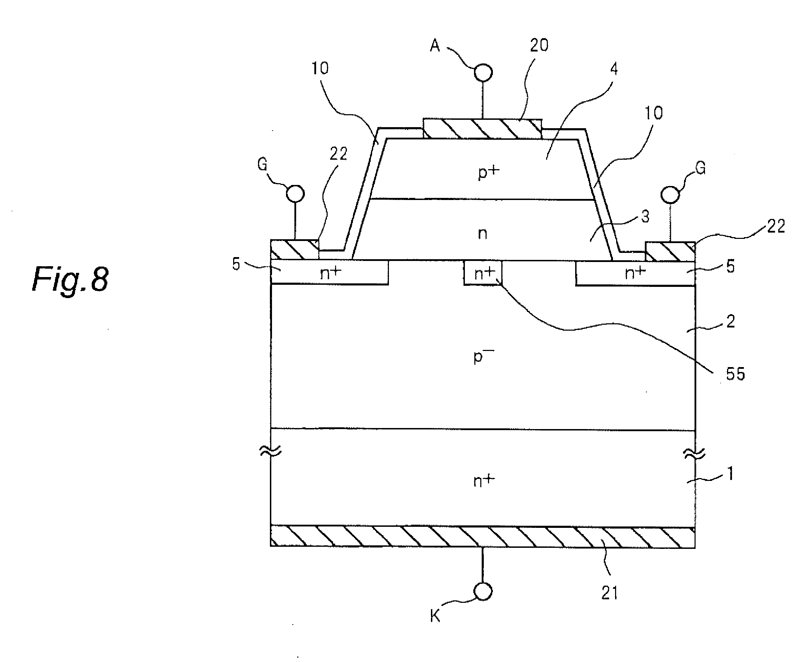

Fig. 8 is a sectional view of a GTO that uses SiC of the seventh embodiment of the present invention. In the GTO of the present embodiment, at least one n-type low-resistance gate small region 55 is formed in the neighborhood of the surface of the p-type base layer 2 within an active region where a principal current flows between the n-type low-resistance gate regions 5 located at both end portions. The other construction is the same as that shown in Fig. 7. In the GTO of the present embodiment, the greater part of the flow of electrons injected from the n-type cathode emitter layer 1 into the p-type base layer 2 at the turn-off time can effectively be diverted into the right and left gate electrodes 22 by the n-type low-resistance gate region 55 formed in the active region. With this arrangement, a GTO of a large controllable current can be provided. Even if the lifetime of the carriers (electrons and holes) becomes long at high temperature when the use temperature exceeds 150°C or when the amount of holes that pass through the n-type base layer 3 and flows into the p-type base layer 2 are increased as a consequence of an increase in the hole density due to an increase in the ionization rate of the p-type anode emitter layer 4, the controllable current is scarcely reduced.

The present invention can also be applied to GTO's that are constituted by interchanging the n-type layers and regions with p-type layers and regions and interchanging the p-type layers and regions with n-type layers and regions in the first through seventh embodiments.

### EIGHTH EMBODIMENT

Fig. 9 is a sectional view of a GTO that uses SiC of the eighth embodiment of the present invention. In the figure, an anode contact electrode 61 is formed in a region excluding the center portion of the upper surface of the mesa-type anode emitter layer 4. An anode electrode 60 connected to the anode A is put in contact with only the central region of the anode emitter layer 4. In a peripheral region excluding the central region of the anode emitter layer 4, the anode electrode 60 is put in contact with the anode emitter layer 4 via the anode contact electrode 61. Nickel is used for the anode contact electrode 61, and gold, of which the contact resistance to the semiconductor layer is higher than nickel, is used for the anode electrode 60. In the present technical field, it is known that, when a metal film is formed on an SiC semiconductor layer, a contact resistance between the two is varied depending on the kind of the metal and heat treatment after the film formation of the metal film besides the electrical conductivity of the metal. Metals of a low contact resistance include nickel, titanium, aluminum, tungsten and composite films of these metals. Metals of a high contact resistance include gold and so on. In the present embodiment, the anode contact electrode 61 of nickel is provided divided into at least right and left two regions and subjected to appropriate heat treatment. A gap between the anode contact electrodes 61 located in the two regions is about 1 µm to 20 µm. The other construction is similar to that of the fifth embodiment shown in Fig. 6. Although an angle between the side surface of the mesa-type anode emitter layer 4 and the surface of the base layer 3 is about 90 degrees in Fig. 9, the present embodiment is also applicable even when the angle is within a range of about 140 degrees to 50 degrees.

In the present embodiment, by virtue of a low contact resistance used for the anode contact electrode 61, the contact resistance between the anode contact layer and the anode emitter layer 4 is reduced. Therefore, an on-state current (Hall current) scarcely flows through the region where the anode electrode 60 is put in direct contact with the anode emitter layer 4 and flows to the anode emitter layer 4 through the portion of the anode contact electrode 61. Therefore, the current flows intensively under the anode contact electrode 61, and a current density in the portion where the anode contact electrode 61 is not located is reduced.

The electron current, which flows from the cathode emitter layer 1, flows through the region where the Hall current is flowing, and therefore, the electron current also leans to the region where the anode contact electrode 61 is located. Therefore, a region of the electron current, where electrons exist in surplus, comes close to the gate contact region 6. Therefore, electrons can efficiently be extracted from the gate G at the turn-off time, and the controllable current is increased. In the case of the present embodiment, the controllable current was increased by 55% in comparison with that of the standard background art example.

Although the present embodiment has had the construction in which the anode contact electrode 61 is provided divided, the anode electrode 60 may be similarly divided. Moreover, a similar effect can be obtained even when the anode electrode 60 is not provided and only the anode contact electrode 61 is provided so long as no problem occurs in terms of bonding.

### NINTH EMBODIMENT

Fig. 10 is a sectional view of a GTO that uses SiC of the ninth embodiment of the present invention. In the figure, an anode contact electrode 71 of a material of a low contact resistance such as nickel is formed on the anode emitter layer 4. A lightly doped p-type region 73 is provided in the central region of the surface of the anode emitter layer 4- An anode electrode 70 is formed on the anode contact electrode 71. The anode electrode 70 is made larger than the anode contact electrode 71, and its end portion is put in direct contact with a peripheral portion of the anode emitter layer 4. The other construction is similar to that of the eighth embodiment. Since the p-type region 73 has a low impurity concentration, a contact resistance between the region 73 and the anode contact electrode 71 is high. Moreover, the internal resistance of the region 73 is also higher than the peripheral anode emitter layer 4. As a result, Hall current flows while being diverted to the right and left going around the center portion, as in the eighth embodiment. Therefore, the electron current also flows while being diverted into the right and left. The region, where electrons exist in surplus due to the diverted electron flows, comes close to the gate contact region 6. Therefore, the electron density is reduced in the central region of the p-type base layer 2. As a result, electrons can efficiently be extracted from the gate, and therefore, the controllable current is increased. Although the angle between the side surface of the mesa-type anode emitter layer 4 and the surface of the base layer 3 is about 90 degrees in Fig. 10, the present embodiment is also applicable even when the angle is within a range of about 140 degrees to 50 degrees.

### TENTH EMBODIMENT

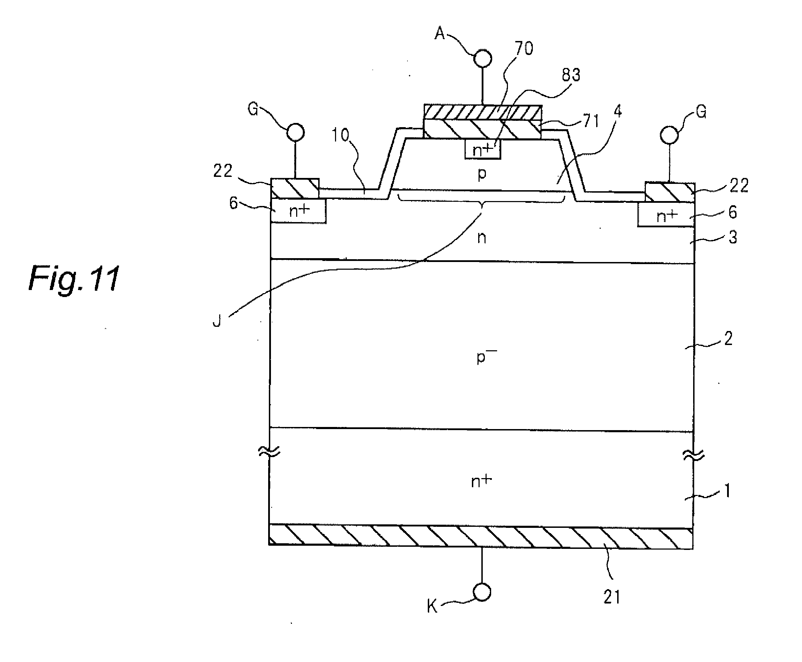

Fig. 11 is a sectional view of a GTO that uses SiC of the tenth embodiment of the present invention. The GTO of the present embodiment differs from that of the ninth embodiment in that a heavily doped n-type region 83 is formed in place of the lightly doped p-type region 73. The other construction is similar to that of the ninth embodiment shown in Fig. 10. Also, in the construction, a current scarcely flows in the central region of the anode emitter layer 4, and Hall current flows while being diverted into the right and left in the anode emitter layer 4. Therefore, an electron current also flows while being diverted into the right and left regions. As a result, the paths of the diverted electron flows come close to the gate contact region 6. Therefore, the control efficiency is improved, and the controllable current is improved. The n-type region 83 can be concurrently formed by ion implantation when the gate contact region 6 is formed, and therefore, the formation processes become simplified.

### ELEVENTH EMBODIMENT

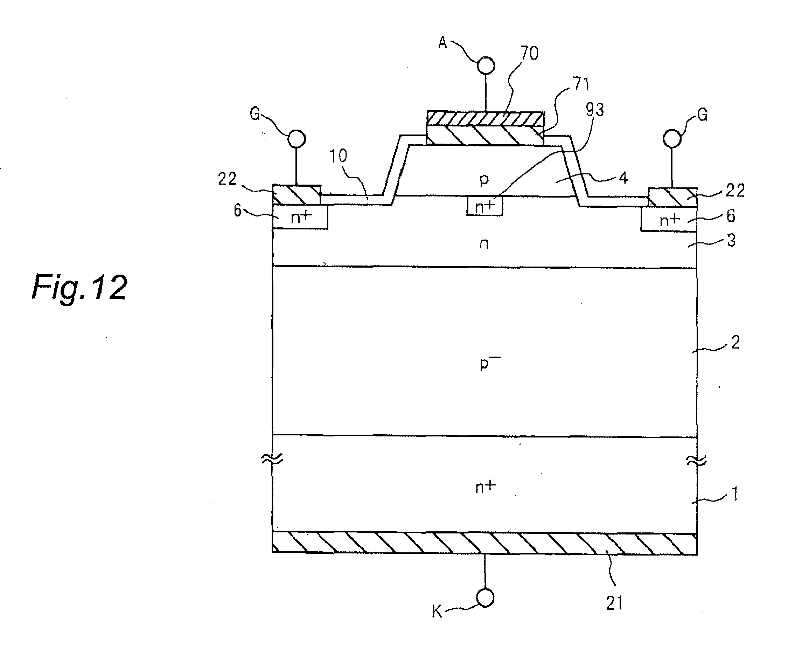

Fig. 12 is a sectional view of a GTO that uses SiC of the eleventh embodiment of the present invention. In the present embodiment, a heavily doped n-type region 93 is provided in a central region of the surface of the n-type base layer 3. The other construction is similar to that of the ninth embodiment shown in Fig. 10. In the construction, the flow of Hall current, which flows from the anode emitter layer 4 toward the cathode emitter layer 1, is disturbed by the n-type region 93 formed in the central region of the base layer 3 and diverted into the right and left in the base layer 3. As a result, the controllable current can be increased by an effect similar to that of the eighth embodiment.

### INDUSTRIAL APPLICABILITY

The present invention can be used for the gate turn-off thyristor that uses a wide-gap semiconductor capable of interrupting a large current within a wide temperature range.

## Claims

1. A gate turn-off thyristor of a wide-gap semiconductor, comprising:
a first emitter layer of either one of n-type and p-type conductive types having a first electrode on its one surface;
a first base layer of a conductive type different from that of the first emitter layer provided on the other surface of the first emitter layer;
a second base layer of a conductive type identical to that of the first emitter layer provided on the first base layer;
a mesa-type second emitter layer of a conductive type different from that of the first emitter layer provided on the second base layer;
a second electrode provided on the mesa-type second emitter layer;
a low-resistance gate region provided so as to surround the mesa-type second emitter layer in a region located apart from an end portion of a junction between the mesa-type second emitter layer and the second base layer, the low-resistance gate region formed in a region that extends from a neighborhood of the end portion of the junction to a bottom portion of the mesa-type second emitter layer with interposition of the second base layer between the region and the junction, the low-resistance gate region having a conductive type identical to that of the second base layer and an impurity concentration higher than that of the second base layer; and
a third electrode put in contact with an end portion of the low-resistance gate region.

2. The gate turn-off thyristor of a wide-gap semiconductor as claimed in claim 1, wherein
a low-resistance region is provided by making the low-resistance gate region have an impurity concentration in the neighborhood of the junction thereof with the third electrode higher than an impurity concentration of the other portion of the low-resistance gate region.

3. The gate turn-off thyristor of a wide-gap semiconductor as claimed in claim 1, wherein
the low-resistance gate region is provided in the second base layer in the neighborhood of the junction between the second emitter layer and the second base layer.

4. The gate turn-off thyristor of a wide-gap semiconductor as claimed in claim 1, further comprising:
a region having a conductive type identical to that of the second emitter layer and provided in the second base layer in the neighborhood of the end portion of the junction between the second base layer and the second emitter layer.

5. The gate turn-off thyristor of a wide-gap semiconductor as claimed in claim 1, wherein
a low-resistance gate region having a conductive type identical to that of the second base layer and provided at a bottom portion of a mesa that includes the neighborhood of the junction between the mesa-type second emitter layer and the second base layer in a neighborhood of a surface of the second base layer, with interposition of a region of a conductive type identical to that of the second emitter layer between the low-resistance gate region and the end portion of the junction.

6. The gate turn-off thyristor of a wide-gap semiconductor as claimed in claim 1, further comprising:
a low-resistance region having a conductive type identical to that of the second base layer and provided in a position located apart from the junction between the mesa-type second emitter layer and the second base layer in a neighborhood of a surface of the second base layer;
a third electrode put in contact with the low-resistance region; and
a region of a conductive type identical to that of the second emitter layer provided in the second base layer in the neighborhood of the end portion of the junction between the second base layer and the second emitter layer.

7. The gate turn-off thyristor of a wide-gap semiconductor as claimed in claim 1, wherein
the second base layer is formed into a mesa type, and a low-resistance gate region of a conductive type identical to that of the second base layer is formed in the first base layer so that the region surrounds the mesa-type second base layer.

8. The gate turn-off thyristor of a wide-gap semiconductor as claimed in claim 1 or 7, further comprising:
at least one low-resistance small region of a conductive type identical to that of the low-resistance gate region formed inside the low-resistance gate region.

9. The gate turn-off thyristor of a wide-gap semiconductor as claimed in claim 1, wherein
the first emitter layer is an n-type cathode emitter layer, the first base layer is a p-type base layer, the second base layer is an n-type base layer, the second emitter layer is a p-type anode emitter layer, and the low-resistance gate region is an n-type, and
the first, second and third electrodes are a cathode electrode, an anode electrode and a gate electrode, respectively.

10. The gate turn-off thyristor of a wide-gap semiconductor as claimed in claim 1, wherein
the first emitter layer is a p-type anode emitter layer, the first base layer is an n-type base layer, the second base layer is a p-type base layer, the second emitter layer is an n-type cathode emitter layer, and the low-resistance gate region is a p-type, and
the first, second and third electrodes are an anode electrode, a cathode electrode and a gate electrode, respectively.

11. The gate turn-off thyristor of a wide-gap semiconductor as claimed in claim 1, wherein
the wide-gap semiconductor is silicon carbide (SiC) .

12. The gate turn-off thyristor of a wide-gap semiconductor as claimed in claim 1 or 8, wherein
an impurity concentration of the low-resistance gate region is three or more times an impurity concentration of the base region.

13. A gate turn-off thyristor of a wide-gap semiconductor, comprising:
a first emitter layer of either one of n-type and p-type conductive types having a first electrode on its one surface;
a first base layer of a conductive type different from that of the first emitter layer provided on the other surface of the first emitter layer;
a second base layer of a conductive type identical to that of the first emitter layer provided on the first base layer;
a mesa-type second emitter layer of a conductive type different from that of the first emitter layer provided on the second base layer;
a contact electrode put in contact with the mesa-type second emitter layer in a region excluding a central region of the second emitter layer;
a low-resistance region provided so as to surround the mesa-type second emitter layer in a region located apart from an end portion of a junction between the mesa-type second emitter layer and the second base layer, the low-resistance region having a conductive type identical to that of the second base layer and an impurity concentration higher than that of the second base layer; and
a second electrode put in contact with an end portion of the low-resistance region.

14. A gate turn-off thyristor of a wide-gap semiconductor, comprising:
a first emitter layer of either one of n-type and p-type conductive types having a first electrode on its one surface;
a first base layer of a conductive type different from that of the first emitter layer provided on the other surface of the first emitter layer;
a second base layer of a conductive type identical to that of the first emitter layer provided on the first base layer;
a mesa-type second emitter layer of a conductive type different from that of the first emitter layer provided on the second base layer;
a high-resistance region provided in a central region of an upper surface of the second emitter layer and having a conductive type identical to that of the second emitter layer and an impurity concentration lower than that of the second emitter layer;
a contact electrode put in contact with the second emitter layer and the high-resistance region;
a second electrode put in contact with the contact electrode and the second emitter layer at least at a peripheral portion of the contact electrode and having a contact resistance to the emitter layer greater than a contact resistance of the contact electrode to the emitter layer;
a low-resistance region provided so as to surround the mesa-type second emitter layer in a region located apart from an end portion of a junction between the mesa-type second emitter layer and the second base layer, the low-resistance region having a conductive type identical to that of the second base layer and an impurity concentration higher than that of the second base layer; and
a third electrode put in contact with an end portion of the low-resistance region.

15. The gate turn-off thyristor as claimed in any one of claims 1, 13 and 14, further comprising:
a region of a conductive type different from that of the second emitter layer provided in a central region of an upper surface of the mesa-type second emitter layer; and
a second electrode located opposite to the second emitter layer and the region via at least a contact electrode.

16. The gate turn-off thyristor as claimed in any one of claims 1, 13 and 14, further comprising:
a heavily doped region provided in a central region of a surface of the second base layer and having a conductive type identical to that of the second base layer and an impurity concentration higher than that of the second base layer;
a mesa-type second emitter layer provided on the second base layer and the heavily doped region and having a conductive type different from that of the first emitter layer; and
a second electrode put in contact with the mesa-type second emitter layer at least via a contact electrode.

## Amended claims

### Amended claims under Art. 19.1 PCT

1. amended) A gate turn-off thyristor of a wide-gap semiconductor, comprising:
a first emitter layer of either one of n-type and p-type conductive types having a first electrode on its one surface;
a first base layer of a conductive type different from that of the first emitter layer provided on the other surface of the first emitter layer;
a second base layer of a conductive type identical to that of the first emitter layer provided on the first base layer;
a mesa-type second emitter layer of a conductive type different from that of the first emitter layer provided on the second base layer;
a second electrode provided on the mesa-type second emitter layer;
a low-resistance gate region provided in the second base layer below a bottom surface of a mesa that surrounds the mesa-type second emitter layer and having a conductive type identical to that of the second base layer and an impurity concentration higher than that of the second base layer; and
a third electrode put in contact with the low-resistance gate region via a gate contact region.

2. The gate turn-off thyristor of a wide-gap semiconductor as claimed in claim 1, wherein
a low-resistance region is provided by making the low-resistance gate region have an impurity concentration in the neighborhood of the junction thereof with the third electrode higher than an impurity concentration of the other portion of the low-resistance gate region.

3. The gate turn-off thyristor of a wide-gap semiconductor as claimed in claim 1, wherein
the low-resistance gate region is provided in the second base layer in the neighborhood of the junction between the second emitter layer and the second base layer.

4. The gate turn-off thyristor of a wide-gap semiconductor as claimed in claim 1, further comprising:
a region having a conductive type identical to that of the second emitter layer and provided in the second base layer in the neighborhood of the end portion of the junction between the second base layer and the second emitter layer.

5. (amended) A gate turn-off thyristor of a wide-gap semiconductor, comprising:
a first emitter layer of either one of n-type and p-type conductive types having a first electrode on its one surface;
a first base layer of a conductive type different from that of the first emitter layer provided on the other surface of the first emitter layer;
a second base layer of a conductive type identical to that of the first emitter layer provided on the first base layer;
a mesa-type second emitter layer of a conductive type different from that of the first emitter layer provided on the second base layer;
a second electrode provided on the mesa-type second emitter layer; and
a low-resistance gate region having a conductive type identical to that of the second base layer and provided at a bottom portion of a mesa that includes a neighborhood of a junction between the mesa-type second emitter layer and the second base layer in a neighborhood of a surface of the second base layer, with interposition of a region of a conductive type identical to that of the second emitter layer between the low-resistance gate region and an end portion of the junction.

6. (amended) A gate turn-off thyristor of a wide-gap semiconductor, comprising:
a first emitter layer of either one of n-type and p-type conductive types having a first electrode on its one surface;
a first base layer of a conductive type different from that of the first emitter layer provided on the other surface of the first emitter layer;
a second base layer of a conductive type identical to that of the first emitter layer provided on the first base layer;
a mesa-type second emitter layer of a conductive type different from that of the first emitter layer provided on the second base layer;
a second electrode provided on the mesa-type second emitter layer;
a low-resistance region having a conductive type identical to that of the second base layer and provided in a position located apart from the junction between the mesa-type second emitter layer and the second base layer in a neighborhood of a surface of the second base layer;
a third electrode put in contact with the low-resistance region; and
a region of a conductive type identical to that of the second emitter layer provided in the second base layer in the neighborhood of the end portion of the junction between the second base layer and the second emitter layer.

7. (amended) A gate turn-off thyristor of a wide-gap semiconductor, comprising:
a first emitter layer of either one of n-type and p-type conductive types having a first electrode on its one surface;
a first base layer of a conductive type different from that of the first emitter layer provided on the other surface of the first emitter layer;
a second base layer of a conductive type identical to that of the first emitter layer provided on the first base layer;
a mesa-type second emitter layer of a conductive type different from that of the first emitter layer provided on the second base layer; and
a second electrode provided on the mesa-type second emitter layer, wherein
the second base layer is formed into a mesa type, and a low-resistance gate region of a conductive type identical to that of the second base layer is formed in the first base layer so that the region surrounds the mesa-type second base layer.

8. (amended) The gate turn-off thyristor of a wide-gap semiconductor as claimed in claim 7, further comprising:
at least one low-resistance small region of a conductive type identical to that of the low-resistance gate region formed inside the low-resistance gate region.

9. The gate turn-off thyristor of a wide-gap semiconductor as claimed in claim 1, wherein
the first emitter layer is an n-type cathode emitter layer, the first base layer is a p-type base layer, the second base layer is an n-type base layer, the second emitter layer is a p-type anode emitter layer, and the low-resistance gate region is an n-type, and
the first, second and third electrodes are a cathode electrode, an anode electrode and a gate electrode, respectively.

10. The gate turn-off thyristor of a wide-gap semiconductor as claimed in claim 1, wherein
the first emitter layer is a p-type anode emitter layer, the first base layer is an n-type base layer, the second base layer is a p-type base layer, the second emitter layer is an n-type cathode emitter layer, and the low-resistance gate region is a p-type, and
the first, second and third electrodes are an anode electrode, a cathode electrode and a gate electrode, respectively.

11. The gate turn-off thyristor of a wide-gap semiconductor as claimed in claim 1, wherein
the wide-gap semiconductor is silicon carbide (Sic).

12. The gate turn-off thyristor of a wide-gap semiconductor as claimed in claim 1 or 8, wherein
an impurity concentration of the low-resistance gate region is three or more times an impurity concentration of the base region.

13. A gate turn-off thyristor of a wide-gap semiconductor, comprising:
a first emitter layer of either one of n-type and p-type conductive types having a first electrode on its one surface;
a first base layer of a conductive type different from that of the first emitter layer provided on the other surface of the first emitter layer;
a second base layer of a conductive type identical to that of the first emitter layer provided on the first base layer;
a mesa-type second emitter layer of a conductive type different from that of the first emitter layer provided on the second base layer;
a contact electrode put in contact with the mesa-type second emitter layer in a region excluding a central region of the second emitter layer;
a low-resistance region provided so as to surround the mesa-type second emitter layer in a region located apart from an end portion of a junction between the mesa-type second emitter layer and the second base layer, the low-resistance region having a conductive type identical to that of the second base layer and an impurity concentration higher than that of the second base layer; and
a second electrode put in contact with an end portion of the low-resistance region.

14. (amended) A gate turn-off thyristor of a wide-gap semiconductor, comprising:
a first emitter layer of either one of n-type and p-type conductive types having a first electrode on its one surface;
a first base layer of a conductive type different from that of the first emitter layer provided on the other surface of the first emitter layer;
a second base layer of a conductive type identical to that of the first emitter layer provided on the first base layer;
a mesa-type second emitter layer of a conductive type different from that of the first emitter layer provided on the second base layer;
a high-resistance region provided in a central region of an upper surface of the second emitter layer and having a conductive type identical to that of the second emitter layer and an impurity concentration lower than that of the second emitter layer;
a second electrode put in contact with the second emitter layer and the high-resistance region;
a low-resistance region provided in a region located apart from an end portion of a junction between the mesa-type second emitter layer and the second base layer so that the region surrounds the mesa-type second emitter layer, the low-resistance region having a conductive type identical to that of the second base layer and an impurity concentration higher than an impurity concentration of the second base layer; and
a third electrode put in contact with an end portion of the low-resistance region.

15. (amended) A gate turn-off thyristor of a wide-gap semiconductor, comprising:
a first emitter layer of either one of n-type and p-type conductive types having a first electrode on its one surface;
a first base layer of a conductive type different from that of the first emitter layer provided on the other surface of the first emitter layer;
a second base layer of a conductive type identical to that of the first emitter layer provided on the first base layer;
a mesa-type second emitter layer of a conductive type different from that of the first emitter layer provided on the second base layer;
a region of a conductive type different from that of the second emitter layer provided in a central region of an upper surface of the mesa-type second emitter layer; and
a second electrode located opposite to the second emitter layer and the region via at least a contact electrode.

16. (amended) A gate turn-off thyristor of a wide-gap semiconductor, comprising:
a first emitter layer of either one of n-type and p-type conductive types having a first electrode on its one surface;
a first base layer of a conductive type different from that of the first emitter layer provided on the other surface of the first emitter layer;
a second base layer of a conductive type identical to that of the first emitter layer provided on the first base layer;
a heavily doped region provided in a central region of a surface of the second base layer and having a conductive type identical to that of the second base layer and an impurity concentration higher than that of the second base layer;
a mesa-type second emitter layer provided on the second base layer and the heavily doped region and having a conductive type different from that of the first emitter layer; and
a second electrode put in contact with the mesa-type second emitter layer at least via a contact electrode.
